Europäisches Patentamt

European Patent Office

Office européen des brevets

(19)

(11) **EP 1 290 783 B1**

(12) **FASCICULE DE BREVET EUROPEEN**

(45) Date de publication et mention
de la délivrance du brevet:
**03.03.2004 Bulletin 2004/10**

(21) Numéro de dépôt: **01938325.6**

(22) Date de dépôt: **23.05.2001**

(51) Int Cl.7: **H03C 3/09**

(86) Numéro de dépôt international:
**PCT/FR2001/001606**

(87) Numéro de publication internationale:
**WO 2001/093415 (06.12.2001 Gazette 2001/49)**

(54) **SYNTHETISEUR A MODULATION NUMERIQUE**

MODULATOR UNTER VERWENDUNG DIGITALER SYNTHESE

DIGITAL MODULATION SYNTHESIZER

(84) Etats contractants désignés:
**AT BE CH CY DE DK ES FI FR GB GR IE IT LI LU
MC NL PT SE TR**

(30) Priorité: **31.05.2000 FR 0007059**

(43) Date de publication de la demande:
**12.03.2003 Bulletin 2003/11**

(73) Titulaire: **NORTEL NETWORKS France
78117 Châteaufort (FR)**

(72) Inventeurs:
• **VILCOCQ, Guillaume
F-92400 Courbevoie (FR)**

• **BRUN, Corinne
F-78350 Jouy En Josas (FR)**

(74) Mandataire: **Verdure, Stéphane
Cabinet Plasseraud
65/67 rue de la Victoire
75440 Paris Cedex 09 (FR)**

(56) Documents cités:
**EP-A- 0 961 412          WO-A-98/34339
WO-A-99/14859          WO-A-99/43080**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Printed by Jouve, 75001 PARIS (FR)

## Description

La présente invention se rapporte à un synthétiseur à modulation numérique, plus connu sous le vocable DMS (de l'anglais « Digitally Modulated Synthesiser »). Un tel circuit peut être utilisé pour la génération d'un signal radiofréquence (dans la bande UHF comprise entre 400 et 600 MHz) modulé en fréquence ou en phase. Elle trouve des applications dans les émetteurs d'un système de radiocommunication, dans les stations de base et/ou dans les stations mobiles.

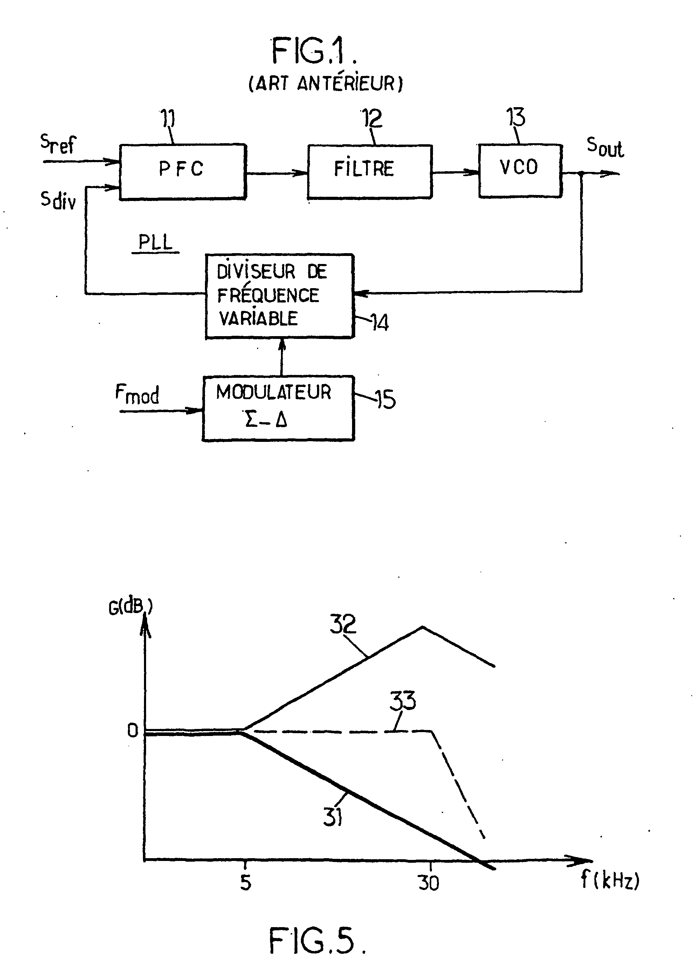

Un DMS présente une architecture qui est dérivée de la structure d'un synthétiseur de fréquence fractionnaire, et permet de générer un signal périodique modulé en fréquence ou en phase. Le schéma fonctionnel d'un DMS connu dans l'état de l'art est représenté à la figure 1. Le DMS comporte une boucle à verrouillage de phase 10 ou PLL (de l'anglais « Phase Locked Loop ») comprenant en série un comparateur de phase/fréquence 11 ou PFC (de l'anglais « Phase/Frequency Comparator »), un filtre de boucle 12 tel qu'un intégrateur, et un oscillateur commandé en tension 13 ou VCO (de l'anglais « Voltage Controlled Oscillator »), ainsi que, dans la voie de retour, un diviseur de fréquence 14. Le VCO délivre en sortie un signal $S_{out}$ qui est le signal de sortie du DMS, dont la fréquence instantanée est fout. Le PFC reçoit sur une première entrée un signal de référence $S_{ref}$ ayant une fréquence de référence $f_{ref}$ et, sur une seconde entrée, un signal $S_{div}$ obtenu par le diviseur de fréquence 14 à partir du signal $S_{out}$. Pour une synthèse fractionnaire classique, le diviseur de fréquence 14 est un diviseur à rapport variable permettant de produire le signal $S_{div}$ en divisant la fréquence fout du signal $S_{out}$ par un rapport de division qui vaut alternativement un entier N pendant une fraction A du temps, et l'entier N+1 pendant une fraction B du temps, en sorte que la fréquence $f_{out}$ du signal de sortie $S_{out}$ est donnée en fonction de la fréquence $f_{ref}$ du signal de référence $S_{ref}$, par :

$$f_{out} = \left( N + \frac{B}{A+B} \right) \times f_{ref} \qquad (1)$$

Le document EP 0 961 412 A1 divulgue un synthétiseur similaire.

Le diviseur de fréquence 14 comporte une entrée de commande du rapport de division. Ce rapport est fixé par un accumulateur de la façon décrite précédemment.

Toutefois, afin d'éviter l'apparition de raies parasites dans le spectre du signal de sortie $S_{out}$ dues à la périodicité des changements du rapport de division de N à N+1 et réciproquement, le DMS connu dans l'état de l'art comporte en outre un modulateur 15, du type d'un modulateur $\Sigma$-$\Delta$. Le modulateur 15 comporte une entrée qui reçoit un signal numérique de modulation de fréquence $F_{mod}$, et une sortie qui délivre un signal $S_c$ correspondant au signal $F_{mod}$ embrouillé. La sortie du modulateur 15 est reliée à l'entrée de commande du diviseur 14 pour y délivrer le signal $S_c$. Ainsi connecté, le modulateur 15 permet de faire en sorte que le signal $S_c$ appliqué à chaque instant sur l'entrée de commande du diviseur de fréquence 14 soit un signal pseudo-aléatoire, ce qui rompt la périodicité des changements du rapport de division.

Ainsi qu'il est connu, un modulateur $\Sigma$-$\Delta$ opère un sur-échantillonnage et introduit dans la PLL, un bruit de quantification. Selon une caractéristique intrinsèque de ce type de modulateur, le bruit de quantification est mis en forme de manière que son spectre présente une pente croissante avec la fréquence. Dit autrement, le modulateur $\Sigma$-$\Delta$ assure une mise en forme du bruit de quantification (« Noise Shaping », en anglais) telle que le bruit de quantification est essentiellement présent dans les fréquences élevées.

Ce bruit de quantification se traduit par un bruit de phase dans le signal de sortie $S_{out}$ généré par le VCO. Pour éliminer le bruit de quantification introduit par le modulateur $\Sigma$-$\Delta$, il peut s'avérer nécessaire de régler la fréquence de coupure $f_c$ de la PLL sur une valeur pouvant être inférieure à la fréquence maximum $f_{mod}$ de la bande utile du signal de modulation de fréquence $F_{mod}$. Afin de ne pas détériorer la modulation du signal de sortie $S_{out}$, on se propose d'appliquer une pré-accentuation au signal de modulation $F_{mod}$. Cette pré-accentuation est introduite par un filtre numérique, dont la fonction de transfert est adaptée à celle de la PLL dans une bande utile. De plus, afin de tenir compte des dispersions de caractéristique des composants analogiques constituant la PLL (essentiellement des composants du filtre 12 et du VCO), de leur dérive en température et/ou de leur vieillissement, qui font varier le gain en boucle ouverte de la PLL et donc sa fréquence de coupure, l'invention propose, pour le filtre pré-accentuation, un filtre numérique programmable associé à des moyens de calibration automatique.

En effet, l'invention propose un synthétiseur à modulation numérique pour la génération d'un signal de sortie radiofréquence modulé en fréquence ou en phase comprenant :

- un filtre de pré-accentuation recevant un signal numérique de modulation de fréquence en entrée, pour pré-accentuer le signal de modulation de fréquence et produire un signal de modulation de fréquence pré-accentué ;
- un modulateur $\Sigma$-$\Delta$ ayant une entrée recevant le signal de modulation de fréquence pré-accentué et une sortie délivrant un signal de modulation de fréquence pré-accentué et embrouillé ;

- une boucle à verrouillage de phase avec un diviseur de fréquence à rapport variable dans le chemin de rétroaction, le diviseur de fréquence à rapport variable ayant une entrée de commande du rapport de division reliée à la sortie du modulateur Σ-Δ pour recevoir le signal de modulation de fréquence pré-accentué et embrouillé, le filtrage par la boucle à verrouillage de phase permettant de filtrer le bruit de quantification introduit par le modulateur Σ-Δ et le filtre de pré-accentuation appliquant une pré-accentuation au signal de modulation de fréquence permettant de compenser l'effet de ce filtrage à l'intérieur d'une bande utile ;
- des moyens de calibration automatique du filtre de pré-accentuation permettant d'ajuster la fonction de transfert du filtre de pré-accentuation à celle de la PLL.

Ainsi, le filtrage passe-bas par la PLL permet d'éliminer le bruit de quantification introduit par le modulateur Σ-Δ dans la PLL, et la pré-accentuation du signal de modulation par le filtre de pré-accentuation permet de compenser l'effet de ce filtrage passe-bas sur la modulation du signal de sortie $S_{out}$. Enfin, les moyens de calibration automatique du filtre de pré-accentuation permettent d'assurer, dans la bande utile, l'adéquation de la fonction de transfert de ce filtre à celle de la PLL en toutes circonstances.

Le filtre de pré-accentuation, qui est un filtre numérique programmable, est défini par un certain nombre de coefficients. L'invention propose un filtre numérique ayant une fonction de transfert définie de façon judicieuse en sorte qu'un seul de ces coefficients, appelé coefficient déterminant, dépend du gain en boucle ouverte de la PLL. Cela simplifie un algorithme de calibration mis en oeuvre par les moyens de calibration automatique du filtre de pré-accentuation. En effet, ces moyens peuvent alors comprendre une simple table donnant, en fonction d'un paramètre de qualité de la modulation du signal de sortie du synthétiseur, la valeur du coefficient déterminant qu'il faut programmer dans le filtre de pré-accentuation. Ce paramètre est de préférence l'erreur de phase dans le signal de sortie lorsque ce signal est modulé en phase ou l'erreur de fréquence lorsque ce signal est modulé en fréquence (erreur quadratique moyenne). Mais il peut aussi s'agir de l'indice de modulation du signal de sortie.

D'autres caractéristiques et avantages de l'invention apparaîtront encore à la lecture de la description qui va suivre. Celle-ci est purement illustrative et doit être lue en regard des dessins annexés, sur lesquels on a représenté :

- à la figure 1, déjà analysée : le schéma fonctionnel d'un DMS connu dans l'état de la technique
- à la figure 2 : le schéma fonctionnel d'un DMS selon l'invention ;
- aux figures 3a à 3c : des diagrammes de Bode montrant la fonction de transfert du DMS selon l'invention vis à vis de la modulation ;
- aux figures 4a à 4c: des diagrammes de Bode montrant la fonction de transfert du DMS selon l'invention vis à vis du bruit de quantification ;
- à la figure 5 : un diagramme de Bode donnant une comparaison des fonctions de transfert du filtre de pré-accentuation et de la PLL à l'intérieur d'une bande utile ;
- à la figure 6 : un organigramme des étapes d'un procédé de calibration du filtre de pré-accentuation ;
- à la figure 7 : une courbe montrant l'évolution de l'erreur de phase en fonction de la valeur du coefficient déterminant du filtre de pré-accentuation ;
- à la figure 8 : un schéma fonctionnel d'un circuit intégré intégrant les moyens numériques du DMS selon l'invention.

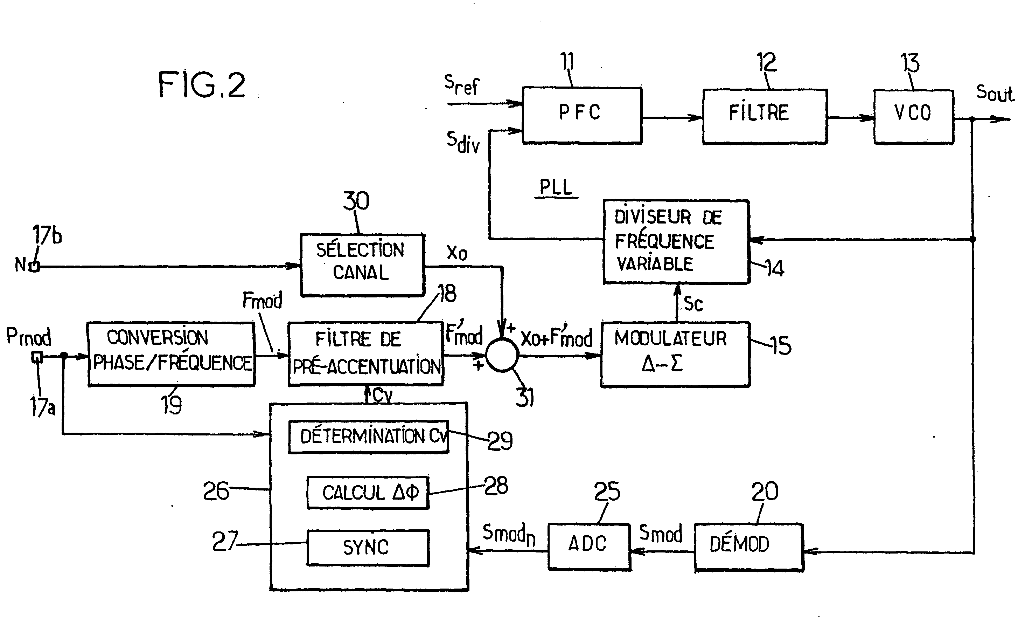

A la figure 2, sur laquelle les mêmes éléments qu'à la figure 1 portent les mêmes références, on a représenté un schéma fonctionnel d'un DMS selon l'invention.

Le DMS selon l'invention comporte une PLL et un modulateur Σ-Δ de même structure que ceux respectifs du DMS de la figure 1. Selon une caractéristique de l'invention, le filtre de boucle 12 de la PLL du DMS de la figure 2 est un intégrateur ayant un étage d'intégration, dont la fréquence de coupure est réglée de manière que le filtrage passe-bas introduit par la PLL permette de filtrer le bruit de quantification introduit par le modulateur Σ-Δ dans le spectre du signal de sortie $S_{out}$. Dans un exemple, la fréquence de coupure $f_c$ de la fonction de transfert de la PLL, est de l'ordre de 5 kHz, pour une fréquence d'échantillonnage du modulateur Σ-Δ égale à 12,8 MHz.

Dans la présente description d'un mode de réalisation de l'invention, on considère l'exemple d'un DMS permettant de générer un signal modulé en phase. Dans ce mode de réalisation, le DMS comporte une entrée de données 17a pour recevoir un signal numérique de modulation de phase $P_{mod}$ et un circuit de conversion 19 recevant le signal $P_{mod}$ en entrée. Ce circuit 19 a pour fonction de produire le signal de modulation de fréquence $F_{mod}$ en sortie, en réalisant une conversion phase/fréquence du signal $P_{mod}$. Ceci n'est toutefois pas limitatif et un DMS selon l'invention peut également être utilisé pour générer un signal modulé en fréquence. La valeur de la fréquence maximum $f_{mod}$ de la bande utile du signal de modulation de phase $P_{mod}$ et du signal de modulation de fréquence $F_{mod}$ se situe dans la bande 8-16 kHz. Elle est donc typiquement supérieure à la valeur de la fréquence de coupure $f_c$ de la fonction de transfert de la PLL qui est, comme indiqué précédemment sensiblement égale à 5 kHz dans l'exemple. Le filtrage passe-bas par la PLL a donc un effet sur la modulation du signal de sortie $S_{out}$.

C'est pourquoi, afin de ne pas détériorer la modulation du signal de sortie $S_{out}$, le DMS selon l'invention se distingue en outre de celui de la figure 1 en ce qu'il comporte un filtre de pré-accentuation 18 qui reçoit le signal de modulation de fréquence $F_{mod}$ en entrée. Ce filtre 18 a pour fonction de pré-accentuer le signal $F_{mod}$ pour produire en sortie un signal de modulation de fréquence pré-accentué $F'_{mod}$. Plus particulièrement, on verra plus loin que le filtre 18 a pour fonction d'appliquer une pré-accentuation au signal de modulation de fréquence $F_{mod}$, permettant, dans une bande utile, de compenser le filtrage passe-bas par la PLL.

Dans un exemple, le DMS comporte en outre une entrée 17b pour recevoir un numéro de canal NC, et un module de sélection de canal 30 recevant le numéro de canal NC en entrée. Ce module 30 a pour fonction de générer, à partir du numéro de canal NC, un signal de canal $X_o$ qui est un signal numérique définissant un canal radiofréquence déterminé parmi une pluralité de canaux couverts par l'émetteur incorporant le DMS. Le module 30, qui est par exemple réalisé sous forme logicielle, peut opérer par sélection du signal numérique $X_o$ dans une table indexée par le numéro de canal NC. Le DMS comporte alors un additionneur numérique 31 pour additionner le signal de canal $X_o$ et le signal de modulation de fréquence pré-accentué $F'_{mod}$, et pour délivrer le signal résultant $X_o+F'_{mod}$ sur la première entrée du modulateur 15.

Dit autrement, l'additionneur numérique 31 comporte une première entrée connectée à la sortie du module de sélection de canal 30 pour recevoir le signal de canal $X_o$, une seconde entrée connectée à la sortie du filtre de pré-accentuation 18 pour recevoir le signal de modulation de fréquence pré-accentué $F'_{mod}$, et une sortie connectée à la première entrée du modulateur 15 pour y délivrer le signal $X_o+F'_{mod}$. En sortie de l'additionneur numérique 31, les bits de poids fort du signal résultant $X_o+F'_{mod}$ sont par exemple constitués par les bits du signal de canal $X_o$, alors que ses bits de poids faible sont constitués par les bits du signal de modulation de fréquence pré-accentué $F'_{mod}$. Le module de sélection de canal 30 et l'additionneur numérique 31 permettent à l'émetteur incorporant le DMS de couvrir une pluralité de canaux différents. Ils ne sont toutefois pas obligatoires et la sortie du filtre de pré-accentuation 18 peut être directement connectée à la première entrée du modulateur 15 pour y déliver le signal de modulation de fréquence pré-accentué $F'_{mod}$, lorsque le DMS est incorporé dans un émetteur monocanal. On notera que, appliqué seul (sans le signal de modulation de fréquence pré-accentué $F'_{mod}$), le signal de canal $X_o$ provoque la synthèse d'un signal de sortie $S_{out}$ avec une fréquence $f_{out}$ constante.

Le filtre de pré-accentuation 18 est un filtre numérique programmable de fonction de transfert A(z), qui est déterminée par la valeur de coefficients Cj stocké dans une mémoire. On rappelle que, selon l'invention, le filtre 18 permet de compenser le filtrage passe-bas par la PLL dans une bande utile comprenant la fréquence de coupure $f_{mod}$ du signal de modulation de fréquence $F_{mod}$. En effet, afin de ne pas faire disparaître la modulation de fréquence dans le signal $S_{out}$ en sortie de la PLL, le filtre de pré-accentuation 18 applique une pré-accentuation au signal de modulation de fréquence $F_{mod}$, qui permet de compenser l'effet sur la modulation du filtrage passe-bas par la PLL. Pour que cette compensation soit efficace, la fonction de transfert A(z) est adaptée à la fonction de transfert réelle de la PLL.

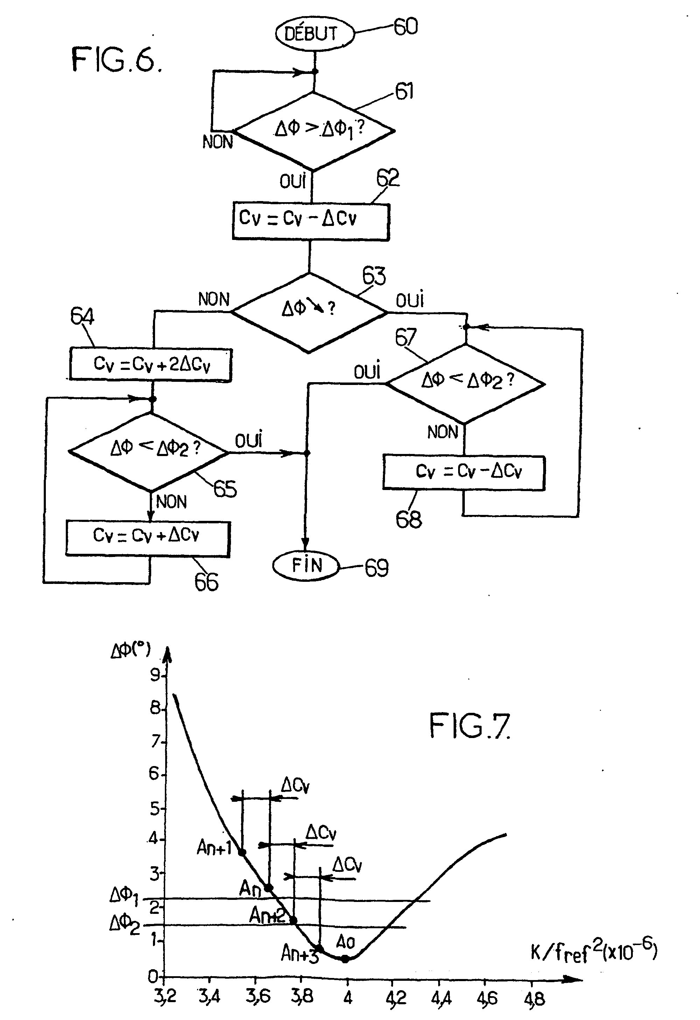

En effet, comme montré sur le diagramme de Bode de la figure 5, la fonction de transfert du filtre de pré-accentuation 18, représentée par la courbe 32, est symétrique de celle de la PLL, représentée par une courbe 31, par rapport à une droite horizontale correspondant à la réponse constante de la PLL dans les basses fréquences. Sur la figure, cette réponse constante correspond à un gain égal à l'unité (0 dB), en sorte que ladite droite horizontale passe par l'origine de l'axe des ordonnées sur lequel les valeurs de gain sont exprimées en décibel (dB). On notera que la symétrie précitée entre la fonction de transfert du filtre de pré-accentuation 18 et celle de la PLL n'a pas besoin d'être obtenue dans tout le spectre. Il suffit en effet de l'obtenir à l'intérieur d'une bande utile incluant la fréquence maximum $f_{mod}$ du signal de modulation de fréquence $F_{mod}$. Dans l'exemple, cette fréquence $f_{mod}$ étant comprise entre 8 et 16 kHz, la symétrie entre les fonctions de transfert 31 et 32 respectivement de la PLL et du filtre de pré-accentuation 18 est obtenue par exemple jusqu'à 30 kHz au moins. Ainsi que le montre la courbe en trait discontinu 33, la réponse globale du synthétiseur vis à vis de la modulation est alors constante à l'intérieur de la bande 0-30 kHz.

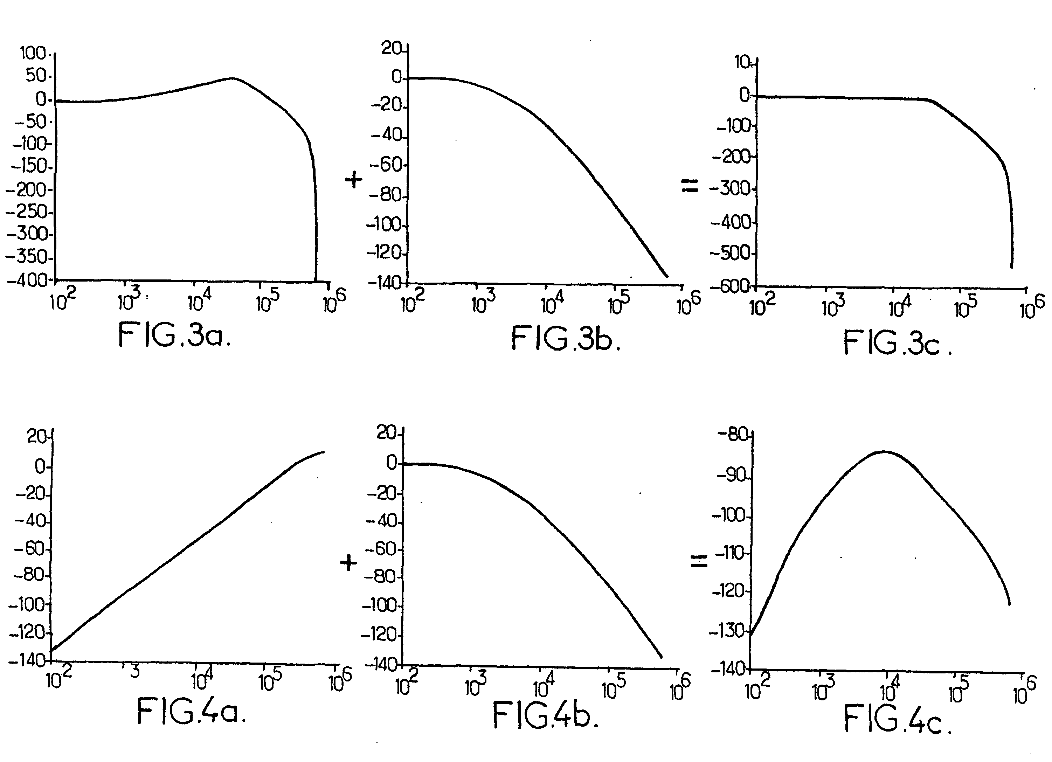

Sur les diagrammes de Bode des figures 3a et 3b, on a représenté respectivement les fonctions de transfert du filtre de pré-accentuation 18 et de la PLL vis à vis de la modulation. L'axe horizontal est gradué en hertzs et l'axe vertical en décibels. La combinaison de ces fonctions de transfert représente le filtrage global appliqué au signal de modulation de fréquence $F_{mod}$ par le DMS selon l'invention, dont la fonction de transfert vis à vis de la modulation est représentée sur le diagramme de Bode de la figure 3c. Ainsi qu'on le voit sur cette dernière figure, le signal de modulation de fréquence $F_{mod}$ n'est pas atténué dans une bande utile allant jusqu'à au moins 30 kHz, en dépit du filtrage passe-bas introduit par la PLL dans cette bande, et ce grâce à la pré-accentuation correspondante introduite par le filtre de pré-accentuation 18.

A l'inverse, on a représenté sur les diagrammes de Bode des figures 4a et 4b, respectivement les fonctions de transfert du modulateur et de la PLL vis à vis du bruit de quantification introduit par le modulateur 15. La combinaison de ces fonctions de transfert représente le filtrage global appliqué à ce bruit de quantification par le DMS selon l'invention, dont la fonction de transfert est représentée sur le diagramme de Bode de la figure 4c. Comme on le voit sur cette dernière figure, le bruit de quantification introduit par le modulateur 15 est fortement atténué dans la bande utile (atténuation supérieure à 80 dB), ce qui correspond à une réjection du bruit de quantification qui est satisfaisante.

Comme précédemment indiqué, il est important que la fonction de transfert du filtre de pré-accentuation soit adaptée à la fonction de transfert réelle de la PLL. Or, la fréquence de coupure $f_C$ de la fonction de transfert de la PLL dépend du gain en boucle ouverte K de la PLL. Celui-ci est donné par l'expression :

$$K = \frac{I_{cp} \times K_{vco}}{C \times \bar{N}} \qquad (2)$$

où $I_{cp}$ désigne le courant dans la pompe de charge du PFD ;

où $K_{vco}$ est la pente du VCO ;

où C est la capacité de l'intégrateur de l'intégrateur 12, déterminée par le valeur d'un condensateur (composant analogique externe) ;

et où $\bar{N}$ est le rapport de division moyen du diviseur de fréquence 14.

Un inconvénient provient du fait que la valeur $K_{vco}$ dépend de la température de fonctionnement du synthétiseur, et aussi de la fréquence synthétisée $f_{out}$. De plus, les valeurs de $K_{vco}$, C et $I_{cp}$ présentent une dispersion de caractéristique qui a également un impact sur la valeur de la fréquence de coupure $f_c$ de la PLL. Ainsi, pour un VCO donné, $K_{VCO}$ peut connaître des dispersions de plus ou moins 25% en fonction de fout, et les variations dues à la température et à la dispersion de caractéristique peuvent être responsables d'une variation de $K_{vco}$ de l'ordre de 28%. Dans une moindre mesure, la valeur C dépend aussi de la température de fonctionnement du synthétiseur et de la fréquence synthétisée $f_{out}$. En outre, la valeur de C peut varier de 1 à 10% selon les exemplaires du condensateur externe. Enfin, la valeur de $I_{cp}$, qui dépend essentiellement de la précision du contrôle numérique mis en oeuvre au moyen d'un convertisseur analogique/numérique 6 bits, peut varier de 2%. En outre, le vieillissement des composants analogiques induit également une variation, à plus long terme, des valeurs de $K_{vco}$, C et $I_{cp}$. Il résulte de toutes ces variations que la fréquence de coupure $f_c$ de la fonction de transfert réelle de la PLL dépend des composants analogiques utilisés pour la fabrication de l'exemplaire du DMS, et qu'elle est susceptible de varier pendant le fonctionnement du DMS avec l'élévation de température, et à plus long terme avec le vieillissement des composants analogiques.

Toutes ces variations peuvent être compensées, selon l'invention, grâce à des moyens de calibration automatique du filtre de pré-accentuation 18. La calibration du filtre 18 opérée par ces moyens est dite automatique en ce sens qu'elle ne nécessite pas un réglage manuel par un opérateur. Ceci permet de rendre possible la fabrication industrielle d'un DMS selon l'invention dans des conditions économiques réalistes. Par calibration du filtre de pré-accentuation, on entend un ajustage dynamique de la fonction de transfert du filtre pour l'adapter à la fonction de transfert réelle de la PLL, de manière que le filtre de pré-accentuation remplisse correctement, en toutes circonstances, sa fonction de compensation de l'effet sur la modulation du filtrage passe-bas par la PLL. Afin de tenir compte de l'effet de la dispersion de caractéristique des composants sur $K_{vco}$, C et/ou $I_{cp}$, et aussi de l'effet du vieillissement des composants analogiques qui interviennent, ces moyens de calibration sont activés à la mise en route de l'émetteur. De plus, afin de tenir compte de l'élévation de la température de fonctionnement lors du fonctionnement de l'émetteur, ils sont également activés à intervalles de temps réguliers, au cours de ce fonctionnement.

Afin de décrire la structure et le fonctionnement des moyens de calibration du filtre de pré-accentuation 18, on décrit tout d'abord, dans ce qui suit, une fonction de transfert judicieuse qui est donnée à ce dernier dans un mode de réalisation préféré.

Pour une PLL dont le filtre de boucle 12 est un intégrateur et dont le PFC comporte une pompe de charge, on peut selon l'invention choisir un filtre de pré-accentuation 18 dont la fonction de transfert A(z), exprimée en fonction de la variable z, s'écrit sous la forme suivante :

$$A(z) = \left[ BL\left( \frac{1}{1 + \frac{s^2}{K} \times \frac{1}{F(s)}} \right) \right]^{-1} \qquad (3)$$

où s désigne la variable de Laplace ;

où BL désigne la transformée bi-linéaire, qui permet de passer d'une expression en fonction de la variable s à une expression en fonction de la variable z ;

où K désigne le gain en boucle ouverte de la PLL ;

et où F(s) est la transformée de Laplace du filtre intégrateur 12 de la PLL sans prendre en compte l'étage d'intégration de ce filtre.

Pour un filtre de boucle du troisième ordre, la transformée de Laplace F(s) peut s'exprimer par :

$$F(s) = \frac{1 + {s}/{R_4 C_4}}{\left(1 + {s}/{R_1 C1}\right) \times \left(1 + {s}/{R_2 C_2}\right) \times \left(1 + {s}/{R_3 C_3}\right)} \qquad (4)$$

où les $R_i$ et $C_i$ désignent respectivement des valeurs de résistance et de capacité.

En vertu de la propriété de linéarité de la fonction bi-linéaire BL, l'expression (3) peut se mettre sous la forme :

$$A(z) = \left[ 1 + \frac{1}{K} \times f_{ref}^2 \times \left(1 - z^{-1}\right)^2 \frac{1}{BL(F(s))} \right] \qquad (5)$$

Dans l'expression (5) ci-dessus, le gain en boucle ouverte K de la PLL n'apparaît que dans un seul coefficient de la fonction de transfert du filtre de pré-accentuation 18, appelé dans la suite coefficient déterminant. On note $C_v$ ce coefficient déterminant. Il est donné par :

$$C_V = \frac{f_{ref}^2}{K} \qquad (6)$$

En résumé, les valeurs $I_{cp}$, $K_{vco}$ et C, qui interviennent dans l'expression (2) du gain en boucle ouverte K de la PLL, n'apparaissent que dans le coefficient déterminant $C_v$ de la fonction de transfert du filtre de pré-accentuation 18. Dit autrement, avec un filtre de pré-accentuation présentant une telle fonction de transfert judicieusement choisie, seul le coefficient déterminant $C_v$ doit être modifié pour tenir compte des variations de $I_{cp}$, $K_{vco}$ et C. Ceci permet d'ajuster de manière simple la fonction de transfert du filtre de pré-accentuation 18 à la fonction de transfert réelle de la PLL.

De retour au schéma de la figure 2 on va maintenant décrire la structure des moyens de calibration automatique du filtre de pré-accentuation 18.

Ces moyens comprennent une boucle auxiliaire comportant des moyens 20 de démodulation du signal de sortie $S_{out}$, un convertisseur analogique/numérique 25 et une unité de calcul 26. Les moyens de démodulation 20 produisent à partir du signal de sortie $S_{out}$ un signal analogique $S_{mod}$ qui correspond à la modulation du signal de sortie $S_{out}$. Par exemple, si le signal $S_{out}$ est un signal modulé en phase de la forme $S_{out}(t) = M.\cos(2.\Pi.f_{ref}.t + m.\varphi_m(t))$, où M et m sont des nombres réels et où $\varphi_m(t)$ traduit la modulation de phase, alors le signal $S_{mod}$ est de la forme $S_{mod}(t) = m.\varphi_m(t)$. L'unité de calcul 26 étant une unité de traitement numérique, le signal analogique $S_{mod}$ est converti en un signal numérique $S_{mod_n}$ au moyen du convertisseur 25. Le signal numérique $S_{mod_n}$ est alors transmis en entrée de l'unité de calcul 26.

On rappelle que dans le présent exemple de réalisation, le signal de sortie $S_{out}$ est un signal radiofréquence modulé en phase. Un paramètre de qualité de la modulation du signal de sortie $S_{out}$ pris en compte est donc préférentiellement l'erreur de phase du signal de sortie $S_{out}$, et l'unité de calcul 26 comprend un module de synchronisation 27. Ce module 27 a pour fonction de synchroniser le signal $S_{mod_n}$ et le signal de modulation de phase $P_{mod}$, de manière à tenir compte du retard du signal $S_{mod_n}$ et par rapport au signal $P_{mod}$ qui résulte du traitement par le DMS. Le module 27 applique un retard ad-hoc au signal de modulation de phase $P_{mod}$, permettant de compenser le retard précité. Ce retard ad-hoc est calculé par maximisation de l'autocorrélation de l'erreur de phase par le module de synchronisation 27. Des moyens équivalents sont prévus lorsque, le signal de sortie $S_{out}$ étant un signal radiofréquence modulé en fréquence, un paramètre de qualité de la modulation du signal de sortie $S_{out}$ pris en compte est l'erreur de fréquence du signal de sortie $S_{out}$. Toutefois, il ne sont pas utiles lorsque, le signal de sortie $S_{out}$ étant un signal radiofréquence modulé en fréquence ou en phase, le paramètre de qualité de la modulation du signal de sortie $S_{out}$ est l'indice de modulation du signal de sortie $S_{out}$.

L'unité de calcul 26 comprend en outre un module 28 de calcul d'un paramètre de qualité de la modulation du signal de sortie $S_{out}$, à savoir dans l'exemple l'erreur de phase $\Delta\phi$ entre le signal de modulation de phase $P_{mod}$ et le signal $S_{mod_n}$ correspondant au signal de sortie Sout. Il s'agit par exemple de l'erreur quadratique moyenne ou erreur R.M.S. (de l'anglais « Root Mean Square »).

L'unité de calcul 26 comprend enfin un module de détermination de la valeur du coefficient déterminant $C_v$.

Ce module opère par sélection dans une table contenant Z valeurs prédéterminées du coefficient $C_v$. Une telle table est par exemple stockée dans une mémoire non volatile à lecture seule telle que la mémoire ROM d'un microcontrôleur. Les valeurs du coefficient $C_v$ disponibles dans cette table sont par exemple des valeurs régulièrement croissantes, avec un pas constant $C_v$. La sélection est réalisée en fonction de l'erreur de phase $\Delta\phi$ produite par le module de calcul 28 selon un algorithme sur lequel on reviendra plus loin. Dans le cas d'un DMS incorporé dans un émetteur multicanaux envisagé ici, on notera qu'il peut être préférable de disposer d'une telle table pour chaque canal ou groupe de canaux couvert par l'émetteur, car les valeurs du coefficient $C_v$ peuvent dépendre de la fréquence du canal sélectionné par le circuit de sélection de canal 30.

Les modules 27, 28 et 29 sont par exemple des modules logiciels réalisés, sous forme de programmes mémorisés dans la mémoire ROM d'un microcontrôleur et exécutés par ledit microcontrôleur lorsque les moyens de calibration sont activés.

A la mise en fonctionnement du DMS, on programme dans le filtre de pré-accentuation 18 successivement les Z valeurs du coefficient déterminant $C_v$ qui sont mémorisées dans la table de valeurs associée au canal sélectionné, et on calcule pour chacune.d'elle l'erreur de phase $\Delta\phi$ du signal de sortie $S_{out}$. On choisit alors celle des valeurs du coefficient $C_v$ qui est la meilleure, c'est à dire celle qui donne la valeur de $\Delta\phi$ la plus faible, et on la programme dans le filtre de pré-accentuation 18. Dit autrement, on teste les Z valeurs du coefficient déterminant $C_v$ disponibles, et on sélectionne la meilleure de ces valeurs, qui est alors programmée dans le filtre de pré-accentuation 18. De préférence, ces tests successifs sont réalisés successivement pour des valeurs identiques du signal de modulation de fréquence $F_{mod}$, c'est à dire aussi du signal de modulation de phase $P_{mod}$. Ceci garantit que le calcul de l'erreur de phase ne soit pas influencé par la valeur de ce signal. Dans un exemple, les tests des Z valeurs de $C_v$ sont réalisés pendant l'émission de la séquence d'apprentissage qui, de façon habituelle, est émise à la mise sous tension de l'émetteur incorporant le DMS. On sait en effet que cette séquence d'apprentissage est une suite de mots binaires identiques.

En cours de fonctionnement, l'unité de calcul 26 des moyens de calibration automatique du filtre de pré-accentuation 18 met en oeuvre un algorithme qui va maintenant être décrit en regard de l'organigramme de la figure 6 et de la courbe de la figure 7.

A la figure 7, on a représenté une courbe montrant, pour un canal sélectionné déterminé et pour des valeurs de $K_{vco}$, C et $I_{cp}$ déterminées, l'évolution de l'erreur de phase $\Delta\phi$ en fonction de la valeur du coefficient déterminant $C_v$ du filtre de pré-accentuation 18. On note $A_o$ le point de cette courbe qui correspondrait à la valeur du coefficient $C_v$ sélectionnée lors de la mise en fonctionnement du DMS. Comme on le voit, le point $A_o$ correspond à un minimum de la courbe. On note $A_n$ le point de la courbe qui correspond à la valeur courante du coefficient $C_v$ programmée dans le filtre 18 à un instant déterminé auquel les moyens de calibration automatique du filtre 18 sont activés.

De préférence, les moyens de calibration automatique du filtre de pré-accentuation sont activés pendant l'émission par un émetteur incorporant le DMS des séquences de synchronisation qui, de façon classique, sont émises à intervalles de temps réguliers, par exemple toutes les 20 ms en mode émission de données. Ces séquences de synchronisation étant constituées par des suites de mots binaires identiques, la calibration automatique du filtre 18 n'est pas influencée par la valeur du signal de modulation. En effet, la valeur de l'erreur de phase $\Delta\phi$ est ainsi calculée pendant l'émission de ces séquences de synchronisation, c'est à dire pour des valeurs identiques du signal de modulation de fréquence.

L'algorithme de calibration automatique du filtre de pré-accentuation 18 représenté par l'organigramme de la figure 6 est mis en oeuvre par le module 29 de l'unité de calcul 26 du DMS selon l'invention. On suppose par hypothèse, que au début 60 de l'algorithme, une valeur déterminée du coefficient $C_v$ est mémorisée dans le filtre 18, en sorte qu'on se situe sur le point $A_n$ sur la courbe de la figure 7.

Dans une étape 61, on compare l'erreur de phase $\Delta\phi$ produite par le module de calcul 28 de l'unité de calcul 26 du DMS à une première valeur de seuil $\Delta\phi_1$. Si $\Delta\phi$ n'est pas supérieur à $\Delta\phi_1$ alors on retourne au début 60. Si au contraire $\Delta\phi$ est supérieur à $\Delta\phi_1$, alors dans une étape 62 on remplace la valeur du coefficient déterminant $C_v$ par sa valeur courante moins le pas $\Delta C_v$. Dans un exemple, cette nouvelle valeur courante du coefficient déterminant $C_v$ amène le point de fonctionnement du DMS à se déplacer sur la courbe de la figure 7 du point $A_n$ au point $A_{n+1}$.

Dans une étape 63 on détermine alors en fonction d'une nouvelle valeur de l'erreur de phase $\Delta\phi$ produite par le module de calcul 28 si l'erreur de phase à diminué par rapport à la valeur précédente du coefficient $C_v$. Si l'erreur de phase n'a pas diminué, alors cela signifie que la valeur du coefficient $C_v$ n'a pas été modifiée dans le bon sens. C'est pourquoi dans une étape 64 on remplace alors la valeur courante du coefficient $C_v$ par la valeur courante augmentée de deux fois le pas $\Delta C_v$. En raison de cette modification de la valeur courante du coefficient $C_v$, le point de fonctionnement du DMS se déplace sur la courbe de la figure 7 du point $A_{n+1}$ au point $A_{n+2}$. Dans une étape 65 on compare alors l'erreur de phase $\Delta\phi$ calculée par le module de calcul 28 de l'unité de calcul 26 à une seconde valeur de seuil $\Delta\phi_2$. Si $\Delta\phi$ est inférieur à $\Delta\phi_2$ on atteint la fin 69 de l'algorithme. Si $\Delta\phi$ n'est pas inférieur à $\Delta\phi_2$, alors il faut encore modifier la valeur du coefficient déterminant $C_v$ dans le même sens. C'est pourquoi dans une étape 66 on remplace la valeur courante du coefficient $C_v$ par la valeur courante augmentée du pas $\Delta C_v$, et l'on retourne à l'étape de comparaison 65 précitée. Dans l'exemple, représenté à la figure 7, cette nouvelle valeur courante du coefficient $C_v$

amène le point de fonctionnement du DMS à se déplacer sur la courbe du point $A_{n+1}$ au point $A_{n+2}$. Dans l'exemple représenté, le point $A_{n+2}$ est encore au-dessus du seuil $\Delta\phi_2$, en sorte qu'une nouvelle itération des étapes 66 et 65 est requise avant d'atteindre la fin 69 de l'algorithme. Le point de fonctionnement du DMS correspond alors au point $A_{n+3}$ de la courbe de la figure 7.

Si à l'étape 63 on détermine au contraire que la valeur de l'erreur de phase $\Delta\phi$ a diminué, alors dans une étape 67, comparable à l'étape 65 précitée, on compare la valeur de l'erreur de phase $\Delta\phi$ à la seconde valeur de seuil $\Delta\phi_2$. Si $\Delta\phi$ est inférieur à $\Delta\phi_2$ alors on atteint la fin 69 de l'algorithme. A l'inverse, si $\Delta\phi$ n'est pas inférieur à $\Delta\phi_2$, on remplace alors dans une étape 68 la valeur courante du coefficient $C_v$ par la valeur courante diminuée du pas $\Delta C_v$ et l'on retourne à l'étape de comparaison 67 précitée.

La valeur de seuil $\Delta\phi_2$ est inférieure à la valeur de seuil $\Delta\phi_1$. Dans un exemple $\Delta\phi_1$ est de l'ordre de $2°$ et $\Delta\phi_2$ est de l'ordre de $1,5°$. L'algorithme décrit ci-dessus en regard de la figure 6 permet donc de maintenir l'erreur de phase $\Delta\phi$ du signal de sortie $F_{out}$ au plus à une valeur de l'ordre de $2°$. Le fait d'avoir deux valeurs de seuil $\Delta\phi_1$ et $\Delta\phi_2$ différentes, $\Delta\phi_2$ étant inférieure à $\Delta\phi_1$, permet à l'algorithme mis en oeuvre par le module de détermination 29 de l'unité de calcul 26 du DMS d'introduire une hystérésis dans l'évolution du point de fonctionnement.

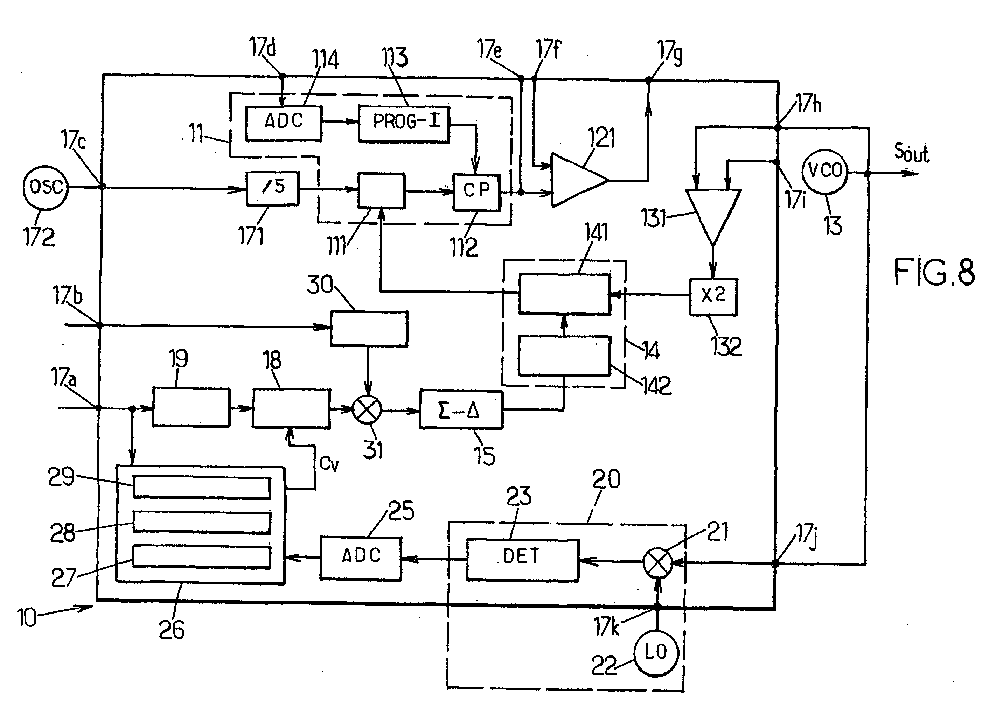

A la figure 8 on a représenté le schéma fonctionnel d'un circuit intégré 10 dans lequel sont intégrés tous les moyens numériques mis en oeuvre dans le DMS selon l'invention. Sur cette figure, les mêmes éléments qu'à la figure 2 portent les mêmes références.

En plus des entrées 17a et 17b déjà décrites en référence à la figure 2, le circuit 10 comprend une entrée 17c et un diviseur de fréquence 171. En fonctionnement, l'entrée 17c est connectée à un oscillateur externe 172 tel qu'un quartz, et délivre un signal d'horloge dont la fréquence est de quelques MHz, sur une entrée du diviseur 171. Celui-ci opère une division de la fréquence du signal d'horloge par cinq, et délivre en sortie le signal de référence $S_{ref}$ . Le comparateur de phase/fréquence 11 comprend ici un comparateur 111 dont une première entrée est connectée à la sortie du diviseur 171 pour recevoir le signal $S_{ref}$ et dont une seconde entrée est connectée à la sortie du diviseur de fréquence à rapport variable 14. Il comprend en outre une pompe de charge 112. La pompe de charge 112 reçoit un signal numérique de commande de courant délivré par la sortie d'un circuit de programmation 113. Le circuit 113 reçoit en entrée un signal numérique délivré par un convertisseur analogique/numérique 114. Ce dernier est connecté à une entrée 17d du circuit 10 pour recevoir un signal analogique de commande du courant de la pompe de charge 112. Ce signal de commande, après conversion analogique/numérique au moyen du convertisseur 114, est utilisé par le circuit de programmation 113 pour délivrer à la pompe de charge le signal numérique de commande de courant. La sortie de la pompe de charge 112 coïncide avec la sortie du PFC 11.

Du filtre 12, le circuit 10 ne comprend qu'un amplificateur opérationnel 121, dont une première entrée est connectée à la sortie du PFC 11 ainsi qu'à une entrée 17e du circuit 10, une seconde entrée de l'amplificateur opérationnel 121 étant connectée à une autre entrée 17f du circuit 10. En fonctionnement, ces deux entrées 17e et 17f sont reliées à des composants discrets externes, dont deux condensateurs et une résistance qui, avec l'amplificateur opérationnel 121, forment un intégrateur dont la fréquence de coupure est déterminée par la valeur desdits condensateurs et de ladite résistance. La sortie de l'amplificateur opérationnel 121 est reliée à une sortie 17g du circuit 10.

On notera que le VCO n'est pas intégré dans le circuit 10 mais est un circuit externe. Par souci de simplification, l'entrée du VCO 13, qui en fonctionnement, est connectée à la sortie 17g du filtre 12 n'est pas représentée à la figure 8. Le circuit 10 comprend une entrée 17h qui, en fonctionnement, est connectée à la sortie du VCO 13 pour recevoir le signal de sortie $S_{out}$. Il comprend en outre une entrée 17i qui, en fonctionnement, est reliée à la masse. Il comprend un amplificateur opérationnel 131 fonctionnant en comparateur analogique, dont les entrées sont connectées respectivement à l'entrée 17h et à l'entrée 17i du circuit 10, et dont la sortie est connectée à l'entrée du diviseur de fréquence à rapport variable 14 via un doubleur de fréquence 132.

Sur le schéma de la figure 8, le diviseur de fréquence à rapport variable 14 comprend un diviseur de fréquence 141 couplé à un bloc de logique combinatoire 142. L'entrée du bloc de logique combinatoire est connectée à la sortie du modulateur $\Sigma$-$\Delta$ 15 et constitue l'entrée de commande du rapport de division du diviseur de fréquence à rapport variable 14.

Des moyens de démodulation 20, le circuit 10 comprend un mélangeur de fréquence 21 et un détecteur de fréquence 23. Le mélangeur 21 comprend une première entrée qui est connectée à une entrée 17j du circuit 10 et une seconde entrée qui est connectée à une entrée 17k du circuit 10. En fonctionnement, ces entrées 17j et 17k sont respectivement connectées à la sortie du VCO 13 pour recevoir le signal de sortie $S_{out}$ et à la sortie d'un oscillateur local 22, qui est également externe par rapport au circuit 10 pour recevoir un signal à une fréquence intermédiaire. La sortie du mélangeur 21, est connectée à une entrée du détecteur 23, dont la sortie correspond à la sortie des moyens de démodulation 20, et est donc connectée à l'entrée du convertisseur analogique/numérique 25.

Comme on peut le constater sur le schéma de la figure 8, le circuit 10 intègre la plupart des moyens du DMS. Seuls les moyens analogiques constitués par le VCO 13, l'oscillateur local 22, l'oscillateur 172, et la résistance et le condensateur de l'intégrateur 12 sont des composants externes par rapport au circuit 10. L'invention permet donc la réalisation d'un DMS avec un haut degré d'intégration. La réalisation d'un DMS selon l'invention est donc peu coûteuse et peut être envisagée dans les applications de grande série. Tout ceci est particulièrement avantageux dans le cas des équipements de téléphonie mobile.

**Revendications**

1. Synthétiseur à modulation numérique pour la génération d'un signal de sortie ($S_{out}$) radiofréquence modulé en fréquence ou en phase comprenant :

   - un filtre de pré-accentuation (18) recevant un signal numérique de modulation de fréquence ($F_{mod}$) en entrée, pour pré-accentuer le signal de modulation de fréquence ($F_{mod}$) et produire un signal de modulation de fréquence pré-accentué ($F'_{mod}$) ;

   - un modulateur $\Sigma$-$\Delta$ (15) ayant une entrée recevant le signal de modulation de fréquence pré-accentué ($F'_{mod}$) et une sortie délivrant un signal de modulation de fréquence pré-accentué et embrouillé ($S_c$) ; et

   - une boucle à verrouillage de phase (PLL) avec un diviseur de fréquence à rapport variable (14) dans le chemin de rétroaction, le diviseur de fréquence à rapport variable (14) ayant une entrée de commande du rapport de division reliée à la sortie du modulateur $\Sigma$-$\Delta$ (15) pour recevoir le signal de modulation de fréquence pré-accentué et embrouillé ($S_c$), le filtrage par la boucle à verrouillage de phase (PLL) permettant de filtrer le bruit de quantification introduit par le modulateur $\Sigma$-$\Delta$ (15) et le filtre de pré-accentuation (18) appliquant une pré-accentuation au signal de modulation de fréquence ($F_{mod}$) permettant de compenser l'effet de ce filtrage à l'intérieur d'une bande utile ; **caractérisé en ce que** le synthétiseur comprend en outre

   - des moyens de calibration automatique du filtre de pré-accentuation (18) permettant d'ajuster la fonction de transfert du filtre de pré-accentuation (18) à celle de la boucle de verrouillage de phase (PLL).

2. Synthétiseur selon la revendication 1, comprenant en outre une entrée de données (17a) pour recevoir un signal de modulation de phase ($P_{mod}$), et un circuit de conversion phase/fréquence (19) recevant le signal de modulation de phase ($P_{mod}$) en entrée pour produire le signal de modulation de fréquence ($F_{mod}$) en sortie.

3. Synthétiseur selon la revendication 1 ou la revendication 2, comprenant en outre une entrée (17b) pour recevoir un numéro de canal (NC), un module de sélection de canal (30) recevant le numéro de canal (NC) en entrée pour produire en sortie un signal numérique de canal ($X_o$), et un additionneur numérique (31) ayant une première entrée pour recevoir le signal de canal ($X_o$), une seconde entrée pour recevoir le signal de modulation de fréquence pré-accentué (F'mod), et une sortie reliée à l'entrée du modulateur $\Sigma$-$\Delta$ (15) pour y délivrer un signal dont les bits de poids fort sont les bits du signal de canal ($X_o$) et dont les bits de poids faible sont les bits du signal de modulation de fréquence pré-accentué ($F'_{mod}$).

4. Synthétiseur selon l'une quelconque des revendications précédentes, dans lequel le filtre de pré-accentuation (18) est un filtre numérique programmable dont la fonction de transfert est déterminée par des coefficients enregistrés dans une mémoire, parmi lesquels un seulement, appelé coefficient déterminant, est dépendant du gain en boucle ouverte (K) de la boucle à verrouillage de phase (PLL).

5. Synthétiseur selon la revendication 4 dans lequel, la boucle à verouillage de phase (PLL) comprenant un comparateur de phase/fréquence (11) avec une pompe de charge et un intégrateur (12) ayant un étage d'intégration, la fonction de transfert A(z) du filtre de pré-accentuation (18), exprimée en fonction de la variable z, est du type :

$$A(z) = \left[ 1 + \frac{1}{K} \times f_{ref}^2 \times \left( 1 - z^{-1} \right)^2 \frac{1}{BL(F(s))} \right]$$

où K est le gain en boucle ouverte de la boucle à verrouillage de phase (PLL);
où $f_{ref}$ désigne une fréquence de référence de la boucle à verrouillage de phase (PLL);
où BL désigne la transformée bi-linéaire ;
et où F(s) est la transformée de Laplace du filtre intégrateur (12) de la boucle à verrouillage de phase (PLL) sans prendre en compte l'étage d'intégration.

**6.** Synthétiseur selon l'une des revendications précédentes, dans lequel les moyens de calibration automatique du filtre de pré-accentuation (18) comprennent une boucle auxiliaire comportant des moyens de démodulation (20) du signal de sortie ($S_{out}$) et une unité de calcul (26), l'unité de calcul (26) comprenant un module (28) de calcul d'un paramètre de qualité de la modulation du signal de sortie ($S_{out}$) et un module (29) de détermination du coefficient déterminant du filtre de pré-accentuation (18) en fonction dudit paramètre.

**7.** Synthétiseur selon la revendication 6, dans lequel, la modulation étant une modulation en phase, le paramètre de qualité de la modulation du signal de sortie ($S_{out}$) est l'erreur de phase ($\Delta\phi$) du signal de sortie ($S_{out}$).

**8.** Synthétiseur selon la revendication 6, dans lequel, la modulation étant une modulation en fréquence, le paramètre de qualité de la modulation du signal de sortie ($S_{out}$) est l'erreur de fréquence du signal de sortie ($S_{out}$).

**9.** Synthétiseur selon la revendication 6, dans lequel, la modulation étant une modulation en phase ou en fréquence, le paramètre de qualité de la modulation du signal de sortie ($S_{out}$) est l'indice de modulation du signal de sortie ($S_{out}$).

**10.** Synthétiseur selon l'une quelconque des revendications 4 à 9, comprenant des moyens pour, à la mise en fonctionnement, tester successivement des valeurs déterminées du coefficient déterminant, sélectionner la meilleure de ces valeurs, et la programmer dans le filtre de pré-accentuation (18).

**11.** Synthétiseur selon la revendication 10, comprenant des moyens pour tester successivement lesdites valeurs du coefficient déterminant pour des valeurs identiques du signal de modulation de fréquence ($S_{mod}$).

**12.** Synthétiseur selon la revendication 11, comprenant des moyens pour tester successivement lesdites valeurs du coefficient déterminant pendant la transmission d'une séquence d'apprentissage par un émetteur radiofréquence incorporant le synthétiseur.

**13.** Synthétiseur selon l'une quelconque des revendications 6 à 12, comprenant des moyens pour, en cours de fonctionnement, comparer le paramètre de qualité de la modulation du signal de sortie ($S_{out}$) à un premier seuil ($\phi1$) et à un second seuil ($\phi2$) inférieur audit premier seuil ($\phi1$), et des moyens pour, dès lors que le paramètre de qualité de la modulation du signal de sortie ($S_{out}$) est supérieur audit premier seuil ($\phi1$), modifier la valeur du coefficient déterminant programmée dans le filtre de pré-accentuation (18) jusqu'à ce que le paramètre de qualité de la modulation du signal de sortie ($S_{out}$) soit inférieur audit second seuil ($\phi2$).

**14.** Synthétiseur selon la revendication 13, comprenant des moyens pour calculer la valeur du paramètre ($\Delta\phi$) de qualité de la modulation du signal de sortie ($S_{out}$) pour des valeurs identiques du signal de modulation de fréquence ($F_{mod}$).

**15.** Synthétiseur selon la revendication 14, comprenant des moyens pour calculer la valeur du paramètre ($\Delta\phi$) de qualité de la modulation du signal de sortie ($S_{out}$) pendant la transmission d'une séquence de synchronisation par un émetteur radiofréquence incorporant le synthétiseur.

**16.** Synthétiseur selon l'une des revendications 6 à 15, comprenant une mémoire pour stocker des valeurs déterminées du coefficient déterminant.

**17.** Synthétiseur selon l'une quelconque des revendications précédentes, dans lequel tous les moyens numériques sont intégrés dans un circuit intégré.

**Patentansprüche**

**1.** Synthetisierer mit digitaler Modulation für die Erzeugung eines frequenz- oder phasenmodulierten Hochfrequenz-Ausgangssignals ($S_{out}$), der umfasst:

- ein Voranhebungsfilter (18), das am Eingang ein digitales Frequenzmodulationssignal ($F_{out}$) empfängt, um das Frequenzmodulationssignal ($F_{mod}$) voranzuheben und um ein vorangehobenes Frequenzmodulationssignal ($F'_{mod}$) zu erzeugen;
- einen Modulator $\Sigma$-$\Delta$ (15), der einen Eingang, der das vorangehobene Frequenzmodulationssignal ($F'_{mod}$)

empfängt, und einen Ausgang, der ein vorangehobenes und verwürfeltes Frequenzmodulationssignal ($S_c$) ausgibt, besitzt; und

- eine Phasenverriegelungsschleife (PLL) mit einem Frequenzteiler (14) mit variablem Verhältnis in dem Rückkopplungsweg, wobei der Frequenzteiler (14) mit variablem Verhältnis einen Eingang für die Steuerung des Teilungsverhältnisses besitzt, der mit dem Ausgang des Modulators Σ-Δ (15) verbunden ist, um das vorangehobene und verwürfelte Frequenzmodulationssignal ($S_c$) zu empfangen, wobei die Filterung durch die Phasenverriegelungsschleife (PLL) ermöglicht, das Quantifizierungsrauschen, das durch den Modulator Σ-Δ (15) eingeführt wird, zu filtern, und wobei das Voranhebungsfilter (18) an dem Frequenzmodulationssignal ($F_{mod}$) eine Voranhebung vornimmt, was ermöglicht, die Wirkung dieser Filterung innerhalb eines Nutzbandes zu kompensieren,

   **dadurch gekennzeichnet, dass** der Synthetisierer außerdem umfasst:

- Mittel zur automatischen Kalibrierung des Voranhebungsfilters (18), die ermöglichen, die Übertragungsfunktion des Voranhebungsfilters (18) auf jene der Phasenverriegelungsschleife (PLL) einzustellen.

2.  Synthetisierer nach Anspruch 1, der außerdem einen Dateneingang (17a), der ein Phasenmodulationssignal ($P_{mod}$) empfängt, und eine Phasen/Frequenz-Umsetzungsschaltung (19), die das Phasenmodulationssignal ($P_{mod}$) am Eingang empfängt, um am Ausgang das Frequenzmodulationssignal ($F_{mod}$) zu erzeugen, umfasst.

3.  Synthetisierer nach Anspruch 1 oder Anspruch 2, der außerdem einen Eingang (17b), der eine Kanalnummer (NC) empfängt, ein Kanalauswahlmodul (30), das am Eingang die Kanalnummer (NC) empfängt, um am Ausgang ein digitales Kanalsignal ($X_0$) zu erzeugen, und einen digitalen Addierer (31), der einen ersten Eingang besitzt, um das Kanalsignal ($X_0$) zu empfangen, einen zweiten Eingang besitzt, um das vorangehobene Frequenzmodulationssignal ($F'_{mod}$) zu empfangen, und einen Ausgang besitzt, der mit dem Eingang des Modulators Σ-Δ (15) verbunden ist, um an ihn ein Signal zu liefern, dessen höchstwertige Bits die Bits des Kanalsignals ($X_0$) sind und dessen niedrigstwertige Bits die Bits des vorangehobenen Frequenzmodulationssignals ($F'_{mod}$) sind, umfasst.

4.  Synthetisierer nach einem der vorhergehenden Ansprüche, in dem das Voranhebungsfilter (18) ein programmierbares digitales Filter ist, dessen Übertragungsfunktion durch Koeffizienten bestimmt ist, die in einem Speicher abgelegt sind und von denen ein einziger, der bestimmender Koeffizient genannt wird, von der Verstärkung (K) bei offener Schleife der Phasenverriegelungsschleife (PLL) abhängt.

5.  Synthetisierer nach Anspruch 4, in dem dann, wenn die Phasenverriegelungsschleife (PLL) einen Phasen/Frequenz-Komparator (11) mit einer Ladungspumpe und einem eine Integrationsstufe besitzenden Integrator (12) aufweist, die Übertragungsfunktion A(z) des Voranhebungsfilters (18), ausgedrückt als Funktion der Variable z, von dem folgenden Typ ist:

$$A(z) = \left[ 1 + \frac{1}{K} \cdot f_{ref}^2 \cdot \left( 1 - z^{-1} \right)^2 \frac{1}{BL(F(s))} \right]$$

   wobei K die Verstärkung bei offener Schleife der Phasenverriegelungsschleife (PLL) ist;
   $f_{ref}$ eine Referenzfrequenz der Phasenverriegelungsschleife (PLL) bezeichnet;
   BL die bilineare Transformation bezeichnet; und
   F(s) die Laplace-Transformation des Integratorfilters (12) der Phasenverriegelungsschleife ohne Berücksichtigung der Integrationsstufe ist.

6.  Synthetisierer nach einem der vorhergehenden Ansprüche, in dem die Mittel zur automatischen Kalibrierung des Voranhebungsfilters (18) eine Hilfsschleife umfassen, die Mittel (20) für die Demodulation des Ausgangssignals ($S_{out}$) und eine Recheneinheit (26) aufweist, wobei die Recheneinheit (26) ein Modul (28) zum Berechnen eines Parameters der Qualität der Modulation des Ausgangssignals ($S_{out}$) und ein Modul (29) für die Bestimmung des bestimmenden Koeffizienten des Voranhebungsfilters (18) in Abhängigkeit von diesem Parameter umfasst.

7.  Synthetisierer nach Anspruch 6, in dem dann, wenn die Modulation eine Phasenmodulation ist, der Parameter der Qualität der Modulation des Ausgangssignals ($S_{out}$) der Phasenfehler ($\Delta\phi$) des Ausgangssignals ($S_{out}$) ist.

8. Synthetisierer nach Anspruch 6, in dem dann, wenn die Modulation eine Frequenzmodulation ist, der Parameter der Qualität der Modulation des Ausgangssignals ($S_{out}$) der Frequenzfehler des Ausgangssignals ($S_{out}$) ist.

9. Synthetisierer nach Anspruch 6, in dem dann, wenn die Modulation eine Phasen- oder Frequenzmodulation ist, der Parameter der Qualität der Modulation des Ausgangssignals ($S_{out}$) der Index der Modulation des Ausgangssignals ($S_{out}$) ist.

10. Synthetisierer nach einem der Ansprüche 4 bis 9, der Mittel aufweist, die beim Einschalten nacheinander die bestimmten Werte des bestimmenden Koeffizienten prüfen, den besten dieser Werte auswählen und diesen in dem Voranhebungsfilter (18) programmieren.

11. Synthetisierer nach Anspruch 10, der Mittel umfasst, die nacheinander die Werte des bestimmenden Koeffizienten für gleiche Werte des Frequenzmodulationssignals ($S_{mod}$) prüfen.

12. Synthetisierer nach Anspruch 11, der Mittel umfasst, die die Werte des bestimmenden Koeffizienten während der Übertragung einer Lernsequenz durch einen den Synthetisierer enthaltenden Hochfrequenzsender prüfen.

13. Synthetisierer nach einem der Ansprüche 6 bis 12, der Mittel umfasst, um während des Betriebs den Parameter der Qualität der Modulation des Ausgangssignals ($S_{out}$) mit einem ersten Schwellenwert ($\phi1$) und mit einem zweiten Schwellenwert ($\phi2$), der kleiner als der erste Schwellenwert ($\phi1$) ist, zu vergleichen, und Mittel umfasst, die dann, wenn der Parameter der Qualität der Modulation des Ausgangssignals ($S_{out}$) größer als der erste Schwellenwert ($\phi1$) ist, den in dem Voranhebungsfilter (18) programmierten Wert des bestimmenden Koeffizienten modifizieren, bis der Parameter der Qualität der Modulation des Ausgangssignals ($S_{out}$) kleiner als der zweite Schwellenwert ($\phi2$) ist.

14. Synthetisierer nach Anspruch 13, der Mittel umfasst, die den Wert ($\Delta\phi$) des Parameters der Qualität der Modulation des Ausgangssignals ($S_{out}$) für gleiche Werte des Frequenzmodulationssignals ($F_{mod}$) berechnen.

15. Synthetisierer nach Anspruch 14, der Mittel umfasst, die den Wert ($\Delta\phi$) des Parameters der Qualität der Modulation des Ausgangssignals ($S_{out}$) während der Übertragung einer Synchronisationsfolge von einem den Synthetisierer enthaltenden Hochfrequenzsender berechnen.

16. Synthetisierer nach einem der Ansprüche 6 bis 15, der einen Speicher umfasst, um die bestimmten Werte des bestimmenden Koeffizienten zu speichern.

17. Synthetisierer nach einem der vorhergehenden Ansprüche, in dem alle digitalen Mittel in eine integrierte Schaltung integriert sind.

**Claims**

1. A digital modulation synthesizer for generating a frequency-modulated or phase-modulated radiofrequency output signal ($S_{out}$) comprising:

   - a pre-accentuation filter (18) receiving a frequency modulation digital signal ($F_{mod}$) at the input, for pre-accentuating the frequency modulation signal ($F_{mod}$) and producing a pre-accentuated frequency modulation signal ($F'_{mod}$);
   - a $\Sigma$-$\Delta$ modulator (15) having an input receiving the pre-accentuated frequency modulation signal ($F'_{mod}$) and an output delivering a pre-accentuated and scrambled frequency modulation signal ($S_c$); and
   - a Phase Locked Loop (PLL) with a variable-ratio frequency divider (14) in the feedback path, the variable-ratio frequency divider (14) having a division ratio control input linked to the output of the $\Sigma$-$\Delta$ modulator (15) for receiving the pre-accentuated and scrambled frequency modulation signal ($S_c$), the filtering by the Phase Locked Loop (PLL) making it possible to filter the quantization noise introduced by the $\Sigma$-$\Delta$ modulator (15) and the pre-accentuation filter (18) applying a pre-accentuation to the frequency modulation signal ($F_{mod}$) making it possible to compensate for the effect of this filtering inside a useful band; **characterized in that** the synthetizer further comprises
   - means of automatic calibration of the pre-accentuation filter (18) making it possible to adapt the transfer function of the pre-accentuation filter (18) to that of the Phase Locked Loop (PLL).

2. The synthesizer as claimed in claim 1, furthermore comprising a data input (17a) for receiving a phase modulation signal ($P_{mod}$), and a phase/frequency conversion circuit (19) receiving the phase modulation signal ($P_{mod}$) at input so as to produce the frequency modulation signal ($F_{mod}$) at output.

3. The synthesizer as claimed in claim 1 or claim 2, furthermore comprising an input (17b) for receiving a channel number (NC), a channel selection module (30) receiving the channel number (NC) at input so as to produce at output a channel digital signal ($X_0$), and a digital adder (31) having a first input for receiving the channel signal ($X_0$), a second input for receiving the pre-accentuated frequency modulation signal (F'mod), and an output linked to the input of the Σ-Δ modulator (15) for delivering thereto a signal whose high-order bits are the bits of the channel signal ($X_0$) and whose low-order bits are the bits of the pre-accentuated frequency modulation signal ($F'_{mod}$).

4. The synthesizer as claimed in any one of the preceding claims, in which the pre-accentuation filter (18) is a programmable digital filter whose transfer function is determined by coefficients recorded in a memory, and just one of which, called the determining coefficient, is dependent on the open-loop gain (K) of the Phase Locked Loop (PLL).

5. The synthesizer as claimed in claim 4 in which, the Phase Locked Loop (PLL) comprising a phase/frequency comparator (11) with a charge pump and an integrator (12) having an integration stage, the transfer function A(z) of the pre-accentuation filter (18), expressed as a function of the variable z, is of the type:

$$A(z) = \left[ 1 + \frac{1}{K} \times f_{ref}^2 \times \left( 1 - z^{-1} \right)^2 \frac{1}{BL(F(s))} \right]$$

where K is the open-loop gain of the Phase Locked Loop (PLL);
where $f_{ref}$ denotes a reference frequency of the Phase Locked Loop (PLL);
where BL denotes the bilinear transform;
and where F(s) is the Laplace transform of the integrator filter (12) of the Phase Locked Loop (PLL) disregarding the integration stage.

6. The synthesizer as claimed in one of the preceding claims, in which the means of automatic calibration of the pre-accentuation filter (18) comprise an auxiliary loop comprising means of demodulation (20) of the output signal ($S_{out}$) and a calculation unit (26), the calculation unit (26) comprising a module (28) for calculating a parameter of quality of the modulation of the output signal ($S_{out}$) and a module (29) for determination of the determining coefficient of the pre-accentuation filter (18) as a function of said parameter.

7. The synthesizer as claimed in claim 6, in which, the modulation being a phase modulation, the parameter of quality of the modulation of the output signal ($S_{out}$) is the phase error ($\Delta\phi$) of the output signal ($S_{out}$).

8. The synthesizer as claimed in claim 6, in which, the modulation being a frequency modulation, the parameter of quality of the modulation of the output signal ($S_{out}$) is the frequency error of the output signal ($S_{out}$).

9. The synthesizer as claimed in claim 6, in which, the modulation being a phase modulation or frequency modulation, the parameter of quality of the modulation of the output signal ($S_{out}$) is the modulation index of the output signal ($S_{out}$).

10. The synthesizer as claimed in any one of claims 4 to 9, comprising means for, when making operational, successively testing determined values of the determining coefficient, selecting the best of these values and programming it into the pre-accentuation filter (18).

11. The synthesizer as claimed in claim 10, comprising means for successively testing said values of the determining coefficient for identical values of the frequency modulation signal ($S_{mod}$).

12. The synthesizer as claimed in claim 11, comprising means for successively testing said values of the determining coefficient during the transmission of a learning sequence by a radiofrequency transmitter incorporating the synthesizer.

13. The synthesizer as claimed in any one of claims 6 to 12, comprising means for, while operational, comparing the parameter of quality of the modulation of the output signal ($S_{out}$) with a first threshold ($\phi1$) and with a second threshold ($\phi2$) less than said first threshold ($\phi1$), and means for, as soon as the parameter of quality of the modulation of the output signal ($S_{out}$) is greater than said first threshold ($\phi1$), modifying the value of the determining coefficient programmed into the pre-accentuation filter (18) until the parameter of quality of the modulation of the output signal ($S_{out}$) is less than said second threshold ($\phi2$).

14. The synthesizer as claimed in claim 13, comprising means for calculating the value of the parameter ($\Delta\phi$) of quality of the modulation of the output signal ($S_{out}$) for identical values of the frequency modulation signal ($F_{mod}$).

15. The synthesizer as claimed in claim 14, comprising means for calculating the value of the parameter ($\Delta\phi$) of quality of the modulation of the output signal ($S_{out}$) during the transmission of a synchronization sequence by a radiofrequency transmitter incorporating the synthesizer.

16. The synthesizer as claimed in one of claims 6 to 15, comprising a memory for storing determined values of the determining coefficient.

17. The synthesizer as claimed in one of the preceding claims, in which all the digital means are integrated into an integrated circuit.

# FIG.1.
## (ART ANTÉRIEUR)

# FIG.5.

FIG.2

EP 1 290 783 B1

FIG.3a.   +   FIG.3b.   =   FIG.3c.

FIG.4a.   +   FIG.4b.   =   FIG.4c.

EP 1 290 783 B1

FIG.6.

DÉBUT — 60

$\Delta\Phi > \Delta\Phi_1$? — 61

NON

OUI

$C_V = C_V - \Delta C_V$ — 62

$\Delta\Phi \searrow$ ? — 63

NON

OUI

$C_V = C_V + 2\Delta C_V$ — 64

$\Delta\Phi < \Delta\Phi_2$? — 67

OUI

NON

$\Delta\Phi < \Delta\Phi_2$? — 65

OUI

NON

$C_V = C_V - \Delta C_V$ — 68

$C_V = C_V + \Delta C_V$ — 66

FIN — 69

FIG.7

$\Delta\Phi(°)$

$\Delta C_V$

$\Delta C_V$

$\Delta C_V$

An+1

An

$\Delta\Phi_1$

$\Delta\Phi_2$

An+2

An+3

Ao

$K/f_{ref}^2 (\times 10^{-6})$

FIG.8

EP 1 290 783 B1